# EUROPEAN PATENT APPLICATION

(11) **EP 4 726 773 A1**
(43) Date of publication of application: **15.04.2026**
(21) Application number: 24205441.9
(22) Date of filing: 09.10.2024
(51) Int. Cl.: H01L 23/473, H01L 23/367

(54) **POWER ELECTRONICS DEVICE WITH INTEGRATED PUMP**

(71) Applicant: ABB Schweiz AG, 5400 Baden (CH)
(72) Inventor: KNAPP, Gerold, 5420 Ehrendingen (CH); FRIEDLI, Thomas, 5400 Baden (CH)
(74) Representative: Sykora & König Patentanwälte PartG mbB

(57) **Abstract**

A power electronics device (10) comprises a base plate (16) with a cooling circuit (18); a pump (26) attached to the base plate (16) for conveying cooling fluid (22) through the cooling circuit (18); and at least one semiconductor module (14) attached to a mounting surface (36) of the base plate (16). The cooling circuit (18) comprises at least one receiving opening (24c) in the base plate (16), which receiving opening (24c) is opened towards the mounting surface (36), wherein the at least one receiving opening (24c) is sealed by the at least one semiconductor module (14). The pump (26) and the at least one receiving opening (24c) are interconnected with cooling channels (20a, 20b) running through the base plate (16) below the mounting surface (36), such that the receiving opening (24c) is integrated into the cooling circuit (18), cooling fluid (22) is conveyable by the pump (26) through the at least one receiving opening (24c) and the at least one semiconductor module (14) is directly exposed to the cooling fluid (22), wherein the base plate (16) comprises a cooling interface (51) for cooling the cooling fluid (22).

## Description

### FIELD OF THE INVENTION

The invention relates to a power electronics device.

### BACKGROUND OF THE INVENTION

A large amount of converter systems for traction applications are air cooled and often used heat sinks with fins pointing downwards. Such converter systems may be rooftop or underfloor mounted and may have a height of only about 40 cm.

Air cooling has a lower thermal performance than water cooling due to the limited surface, fins can expose to the cooling air. As heat dissipation concentrates more and more to a very small area on the heat sink, for example when SiC modules with small chip and module size are used, the heat has to transfer laterally in the metal base of the heat sink but is limited by thermal conduction parameters of the metal. Performance therefore is limited, when heat sink size is large compared to the dissipative area or when fins are long.

Heat pipes can enhance heat transfer when they are added to a heat sink system, but they are very expensive and can transport heat only to their close neighboring area, otherwise many of them are needed. Heat pipes may be buried into a metal base plate of the heat sink for better heat spreading from dissipative devices into the rest of the base plate.

It is also possible, that the heat pipes are mounted in a way that they pick up heat in the base plate of the heat sink and at the other end directly reach into an air steam.

Heat sinks with integrated vapor chambers are not commonly used, since they are complex to design.

US 7 327 570 B2 describes an integrated circuit module with a cooling path through the module and a fluid pump attached to the module.

### DESCRIPTION OF THE INVENTION

It is an objective of the present invention to improve the cooling of power semiconductor modules. It is a further objective to improve the spreading of heat in a heat sink.

These objectives are achieved by the subject-matter of the independent claims. Further exemplary embodiments are evident from the dependent claims and the following description.

The invention relates to a power electronics device, in particular to a heat sink to which one or more semiconductor modules are attached.

The power electronics device and in particular the heat sink comprises a base plate with a cooling circuit and a pump attached to the base plate for conveying cooling fluid through the cooling circuit. The base plate may be made of metal, such as copper or aluminium. The cooling circuit may comprise cooling channels integrated into the base plate. The pump may be an electric pump. The cooling fluid in the cooling circuit may be a liquid. Water and/or glycol and/or a mixture thereof may be used as cooling fluid. For example, a mixture of water and glycol may have a working temperature range of -40 up to +100 °C.

The power electronics device furthermore comprises at least one semiconductor module attached to a mounting surface of the base plate. A semiconductor module may comprise one or more semiconductor chips, which may be operated with currents of more than 10 A and/or more than 100 V. The semiconductor chips may be based on SiC, however, also chips based on Si may be used. The semiconductor module furthermore may comprise a housing, in which the chips are arranged. Electric contacts may protrude from the housing, which may be made of plastics material. The housing may have a cooling side for dissipating heat generated by the one or more chips.

It is possible that the power electronics device furthermore comprises at least one electric module attached to the mounting surface of the base plate. More general, an electric module may comprise a resistor, a fuse or other electric or electronic component to be cooled. Such an electric module may be cooled like a semiconductor module, which may be seen as an electric module with a semiconductor chip as electric component. It has to be understood that all the properties mentioned in the following with respect to a semiconductor module also may be properties of an electric module.

The pump and further components, such as the at least one semiconductor module, may be mounted to a mounting surface of the base plate. Mounting may be done with screws or bolts and/or the base plate may comprise mounting holes for receiving such mounting means.

The cooling circuit comprises at least one receiving opening in the base plate, which receiving opening is opened towards the mounting surface and the at least one receiving opening is sealed by the at least one semiconductor module. There may be a receiving opening for each semiconductor module. The semiconductor module and in particular its housing may have a flat face, which is mounted against a border of the receiving opening and which fluid tight seals the receiving opening against an outside of the cooling circuit. For example, a sealing ring may be arranged between the flat face and the border of the receiving opening.

The base plate may have mounting positions for one or more semiconductor modules. A part of the semiconductor module, such as a back side or cooling side, may be directly exposed to the fluid in the receiving opening, which is part of the cooling circuit.

The pump and the at least one receiving opening are interconnected with cooling channels running through the base plate below the mounting surface, such that the receiving opening is integrated into the cooling circuit, cooling fluid is conveyable by the pump through the at least one receiving opening and the at least one semiconductor module is directly exposed to the cooling fluid.

When operated, the cooling fluid pump may distribute the losses of the one or more power modules, which are therefore actively fluid cooled, along the cooling circuit and/or over the entire base plate and/or heat sink. This may improve the thermal performance and/or may lower the resulting thermal resistance of the heat sink. The heat sink and in particular the base plate may be further cooled, for example with a further fluid cooling circuit or by air cooling.

According to an embodiment, the base plate comprises a cooling interface for cooling the cooling fluid. The cooling interface may be a surface of the base plate for dissipating heat and/or for mounting and/or attaching a cooling device. The cooling interface and/or the cooling device may be adapted for transferring heat from the base plate into a further medium, such as air. For example, a heat exchanger may be attached to the cooling interface. As a further example, the cooling interface may provide fins or a cooling body with fins may be attached to the cooling interface.

In this way, an actively actuated liquid cooling circuit may be integrated into an air cooled or natural cooled heat sink. There may be a substantial cooling performance gain for air cooled application and therewith an increase of power density. Tests have shown that a performance enhancement by a factor 2 and higher may be achieved at a relatively low cost increase.

Since the pump is integrated into the heat sink, the power electronics device may be exchanged in the converter without the need for removing the cooling fluid inside the cooling circuit. This may simplify maintenance of the converter system, which comprises one or more of the power electronics devices, such as described herein. Contrary to solutions with heat pipes or vapor chambers, the heat sink works in any orientation.

Mounting of the pump, the at least semiconductor module and further components may be done with screws or bolts and/or the base plate may comprise mounting holes.

According to an embodiment, the semiconductor module comprises a cooling member protruding into the receiving opening. Some or all of the semiconductor modules may have a back side or cooling side providing a cooling member. The cooling member may be arranged inside the respective receiving opening and/or may be directly exposed to the cooling fluid. The cooling member may be provided by pin fins and/or ribbon bonds. In such a way, pin fin modules, which are usually used in liquid cooling converters, also may be used in converter systems without a central liquid cooling system. A converter system composed of power electronics devices, such as described herein, may be locally fluid cooled but globally air cooled. This may be beneficial for traction converters.

In general, due to the presence of receiving opening filled with cooling fluid, the use of power dissipative semiconductor modules with direct liquid contact is enabled. This may enhance the system performance by about 30-40%, which can be estimated by comparing with existing solutions. A module cooling interface with cooling member was developed to enhance the heat transfer in liquid cooled systems by generating a direct contact to the cooling water with large area, avoiding a thermal interface of a thermal grease having substantially lower performance.

It is possible that the pump is mounted to the base plate, such that all its components are outside of the base plate. In this case, the base plate has cooling channel interfaces and/or cooling fluid openings on the mounting surface to connect the pump to the cooling circuit.

According to an embodiment, the cooling circuit comprises a pump opening in the base plate, which may be opened towards the mounting surface, which pump opening is interconnected with the cooling channels in the base plate. The pump may seal the pump opening with a pump body and the pump opening accommodates at least a conveying part or conveyer of the pump. The pump body may accommodate a motor of the pump. The pump may have a flat face, which is mounted against a border of the pump opening and which fluid tight seals the pump opening against an outside of the cooling circuit. A sealing ring may be arranged between the flat face and the border of the pump opening.

The pump opening may be seen as a conveyer section of the cooling circuit. In this section, the cooling channels may be concentrated to a common flow. The pump may be mounted to the pump opening, such that the geometry in the base plate forms a closing part of the pump chamber, so that the conveyer of the pump, such as a pump wheel, is operating within the base plate, driving the fluid flow through the base plate.

By controlling the speed of the pump, the efficiency of the heat sink and/or the power electronics device can be controlled. In particular, a temperature of the one or more semiconductor modules can be controlled, which may decrease the number of temperature cycles and which may increase a lifetime of the power electronics device.

As an example, a propeller wheel of the pump may be rotated directly in the base plate. The housing of the conveyer part of the pump may be provided by the inner surface of the pump opening. The housing geometry for the conveyer may be implemented within the metal base of the heat sink, together with a sealing system to tighten the water circuit at the interface to the pump body.

According to an embodiment, at least one of the cooling channels meanders through the base plate. One or more of the cooling channels may have sections, which run in parallel and are connected by U-shaped sections. A heat spreading section of the base plate having at least the area of a module section providing the receiving openings may provide meandering cooling channels. The meandering cooling channels may cover at least 30% heat spreading section. The cooling circuit may leave the module section and may continue into the rest of the base plate, covering a large area of the base plate to dissipate the heat to the rest of the base plate. This may enable a more uniform heat transfer from the semiconductor modules to the complete base plate. The efficiency of the heat sink may be improved by this heat spreading. The spreading efficiency may be maximum and independent of a size and a shape of the base plate, as long as a full area of the base plate is equipped with cooling channels.

According to an embodiment, the cooling interface is arranged opposite to the mounting surface. The cooling interface may be a surface of the base plate. This surface may be arranged opposite to the mounting surface. The cooling interface may be in parallel to the mounting surface. As an alternative, a part of the mounting surface may provide the cooling interface, where, for example, a cooling device, cooling body and/or fins are attached to the base plate.

According to an embodiment, fins protrude from the base plate. The area of the base plate from which the fins protrude may be seen as cooling interface. The fins may protrude from the base plate opposite to the mounting surface. One side of the base plate, which may provide the mounting interface, may be flat for mounting the semiconductor modules, the pump, and/or other heat dissipating devices like resistors or inductors. The other side of the base plate may be equipped with fins, for example made of copper or aluminium, which are designed to reach into an air stream and transfer the heat into the air stream. The base plate and the fins act like heat conductors that spread the heat (loss power) from the dissipating devices on the mountings side to the fin section of the rear side of the heat sink and/or power electronics device.

It may be that the cooling channels, the one or more receiving openings and the pump opening are integrated into the base plate and form a circular flow path not leaving the base plate. In this case, the fins may be massive and/or the cooling channels are outside of the fins.

According to an embodiment, through at least some of the fins run fin cooling channels, which are interconnected with the cooling channels in the base plate. It also may be that cooling channels are not only within the base plate, but also run through the fins. The fin cooling channels may be circular and/or may enter the fin from the base plate and may return into the base plate. This may improve the heat flow into the fin section for better heat transfer as close as possible to the contact area with cooling air.

According to an embodiment, the base plate cooling channels extend in a plane and at least some of the fin cooling channels protrude from the plane. The cooling channels in the base plate may extend in an extension plane of the base plate. The cooling channels in one fin may extend in an extension plane of the fin, which may be orthogonal to the extension plane of the base plate.

According to an embodiment, the cooling circuit comprises an expansion element opening in the base plate, which may be opened towards the mounting surface. The expansion element opening may be interconnected with the cooling channels in the base plate. The expansion element opening may be sealed with a flexible membrane. The flexible membrane may be covered by a rigid cover for mechanical protection. The expansion element cover may have a flat face, which is mounted against a border of the expansion element opening and which fluid tight seals the expansion element opening against an outside of the cooling circuit. A border of the flexible membrane and/or a sealing ring may be arranged between the flat face and the border of the expansion element opening.

The expansion element may be integrated in the cooling circuit. In general, the expansion element may comprise the expansion element opening, which is closed with the flexible membrane, for example made of rubber, and a cover. This allows the fluid in the cooling circuit to expand and contract due to temperature and pressure variations, which may generate over pressure or under pressure in the closed cooling circuit.

According to an embodiment, at least one of an inlet and outlet interconnected to the cooling circuit is connected to the base plate. The cooling circuit may have an inlet stud and an outlet stud to allow filling and degassing the cooling circuit. The inlet and/or outlet may be closed after the filling. The position of the inlet and the outlet may be selected that during a filling and flushing process, air is moved out of the cooling circuit. A fluid supply may be connected to the inlet, the cooling circuit may be flushed outlet and air may be removed from the cooling circuit. The inlet and/or outlet and/or the studs may comprise self-closing connector elements, which automatically close the opening, when a connecting hose is removed.

It has to be noted that during operation of the power electronics device, the cooling circuit within the power electronics device may be a closed circuit without any connection to other cooling systems and/or devices.

According to an embodiment, the base plate comprises a main plate providing the at least one receiving opening and optionally the pump opening and/or the expansion element opening, as well as the base plate cooling channels. The base plate further comprises a cover plate covering the base plate cooling channels and having holes exposing the at least one receiving opening and optionally the pump opening and/or the expansion element opening.

The cooling channels in the base plate may be closed and/or sealed to the mounting surface by attaching a cover plate to the base plate. For example, the cover plate may be a 2-5 mm thick aluminium sheet. The base plate may be at least 5 times thicker than the cover plate. The cover plate may be bonded to the base plate, for example by standard processes like metal brazing, soldering the cover plate to the base plate, mechanical welding, metal stir welding, etc. The cover plate may have openings to insert the one or more semiconductor modules, the pump, the expansion element and/or the filling studs.

According to an embodiment, the cooling interface is provided by the main plate. A further cooling body may be attached to the main plate and in particular to the cooling interface. According to an embodiment, the at least one receiving opening, the further opening, etc. and the base plate cooling channels are machined into one side of the main plate, in particular into the main plate. The cooling interface may be provided on the other side.

However, it is also possible that the base plate is made by additive manufacturing. In this case, the fins may be made one-piece with the base plate and optionally also may be provided with fin cooling channels.

According to an embodiment, fins are attached to the base plate and in particular to the cooling interface. The main plate may provide the fins protruding from the base plate.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 shows a schematic top view onto a power electronics device according to an embodiment of the invention.
Fig. 2 shows a schematic cross-sectional view of a part of a power electronics device according to an embodiment of the invention.
Fig. 3 shows a schematic cross-sectional view of a part of a power electronics device according to an embodiment of the invention.
Fig. 4 shows a schematic cross-sectional view of a part of a power electronics device according to an embodiment of the invention.
Fig. 5 shows a schematic cross-sectional view of a part of a power electronics device according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

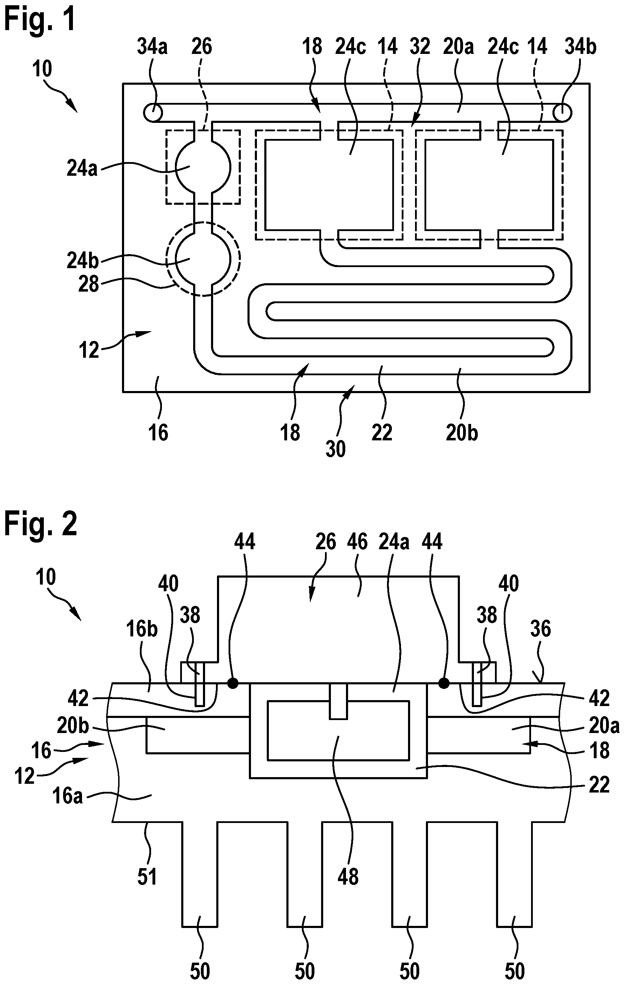

Fig. 1 shows a schematic top view onto a power electronics device 10, which is composed of a heat sink 12 and two semiconductor modules 14. It is possible that the power electronics device 10 comprises solely one semiconductor module 14 or more than two semiconductor modules 14. The semiconductor modules 14 may be electrically connected into a circuit, such as a half-bridge or a converter cell. The power electronics device 10 may comprise further electric and/or electronic components, such as capacitors, resistors, gate drivers, etc.

The heat sink 12 comprises a base plate 16 with a cooling circuit 18. The base plate 16 may be made of metal, such as copper or aluminium.

The cooling circuit 18 comprises cooling channels 20a, 20b integrated into the base plate 16. The cooling fluid 22 in the cooling circuit 18 may be a liquid. Water and/or glycol and/or a mixture thereof may be used as cooling fluid 22.

The cooling circuit 18 furthermore comprises openings 24a, 24b, 24c integrated into the base plate 16. The openings 24a, 24b, 24c are connected to one or more of the cooling channels 20a, 20b and/or are interconnected by the cooling channels 20a, 20b.

The channels 20a, 20b and openings 24a, 24b, 24c may be machined into the base plate 16, for example from one side. It also may be that the base plate 16 is made by additive manufacturing.

The heat sink 12 comprises a pump 26 attached to the base plate 16 for conveying cooling fluid 22 through the cooling circuit 18. The pump 26 is attached to the base plate 16 above a pump opening 24a.

The heat sink 12 comprises an expansion element 28 attached to the base plate 16 for balancing pressure changes and/or volume changes of the cooling fluid 22. The expansion element 28 is attached to the base plate 16 above an expansion element opening 24b.

Each of the semiconductor modules 14 are attached to the base plate 16 above a respective receiving opening 24c. The cooling fluid 22 inside the cooling circuit 18 and in particular inside the respective receiving opening 24c directly contacts a part of the semiconductor modules 14 and heat is transferred to the cooling fluid 22. The pump 26 conveys the cooling fluid 22 through the cooling circuit and the heat is spread into the base plate 16.

All of the components 14, 26, 28 seal the respective openings 24a, 24b, 24c fluid tight, such that the cooling circuit 18 is fluid tight sealed against an environment of the power electronics device 10.

To increase the heat spreading into the complete base plate 16, at least one of the cooling channels 20b may meander through the base plate 16. Sections of the cooling channel 20b run in parallel and are connected by U-shaped sections. The one or more meandering cooling channels 20b may be provided in a heat spreading section 30 of the base plate 16, which heat spreading section 30 has at least the area of a module section 32 providing the receiving openings 24c. The cooling circuit 18 leaves the module section 32 and continues into the rest of the base plate 16, covering a large area of the base plate 16 to dissipate the heat to the rest of the base plate 16.

For filling and degassing the cooling circuit 18 during maintenance, an inlet 34a and an outlet 34b may be connected to the cooling circuit 18. The inlet 34a and the outlet 34b may be provided by studs connected to the base plate 16 and in particular to the cooling circuit 18.

During operation, the inlet 34a and outlet 34b are closed. For this, the inlet 34a and the outlet 34 may comprise self-closing connector elements, which automatically close the opening, when a connecting hose is removed. The position of the inlet 34a and the outlet 34b is selected that during a filling and flushing process, air is moved out of the cooling circuit 18.

Fig. 2 shows a schematic cross-sectional view of the power electronics device 10 in a section, where the pump 26 is attached to the base plate 16. The pump 26, as well as the further components 28, 14, are mounted to a mounting surface 36 of the base plate 16. Mounting may be done with mounting means 38, such as screws or bolts. The base plate 16 comprises mounting holes 40 for receiving such mounting means 38.

The pump 26, as well as the further components 28, 14 (see following figures), have a flat face 42, which is mounted against a border of the respective opening 24a, 24b, 24c and which fluid tight seals the respective opening 24a, 24b, 24c against an outside of the cooling circuit 18. Furthermore, a sealing ring 44 may be arranged between the flat face 42 and the border of the opening 24a, 24b, 24c.

As shown in Fig. 2, the base plate 16 may comprise a main plate 16a providing the openings 24a, 24b, 24c and the cooling channels 20, 20b. The openings 24a, 24b, 24c and the cooling channels 20, 20b may be machined into one side of the main plate 16a.

The base plate 16 may further comprise a cover plate 16b covering the cooling channels 20a, 20b and having holes exposing the openings 24a, 24b, 24c. The cover plate 16b proves the mounting surface 36. The openings 24a, 24b, 24c are opened towards the mounting surface 36. The cooling channels 20a, 20b are closed and/or sealed with respect to the mounting surface 36 by the cover plate 16b, which may be bonded to the main plate 16a.

The pump 26 seals the pump opening 24a with a pump body 46 and the pump opening 24a accommodates at least a conveying part of the pump 26. The pump 26 may be an electric pump and the pump body 46 may accommodate a motor of the pump 26. The pump body 46 provides the flat face 42.

The pump opening 24a may be seen as a conveyer section of the cooling circuit 18. The pump 26 may be mounted to the pump opening 24a, such that the geometry in the base plate 16, i.e., the inner surface of the pump opening 24a, forms a closing part of the pump chamber, so that the conveyer 48 of the pump 26 is operating within the base plate 16, driving the fluid flow through the base plate 16 and/or the cooling circuit 18.

As shown in Fig. 2, the conveyer 48 may be a propeller wheel, which rotates directly in the base plate 16.

It may be that fins 50 protrude from the base plate 16 opposite to the mounting surface 36. One side of the base plate 16 with the mounting surface 36 may be flat for mounting the semiconductor modules 14, the pump 26, the expansion element 28, and/or other heat dissipating devices like resistors or inductors. The other side of the base plate 16 may be equipped with fins 50, which are designed to reach into an air stream and transfer the heat into an air stream. The side and/or surface of the base plate 16 opposite to the mounting surface 36 may be seen as cooling interface 51.

As shown in Fig. 2, the fins 50 may be made one-piece with the main plate 16a.

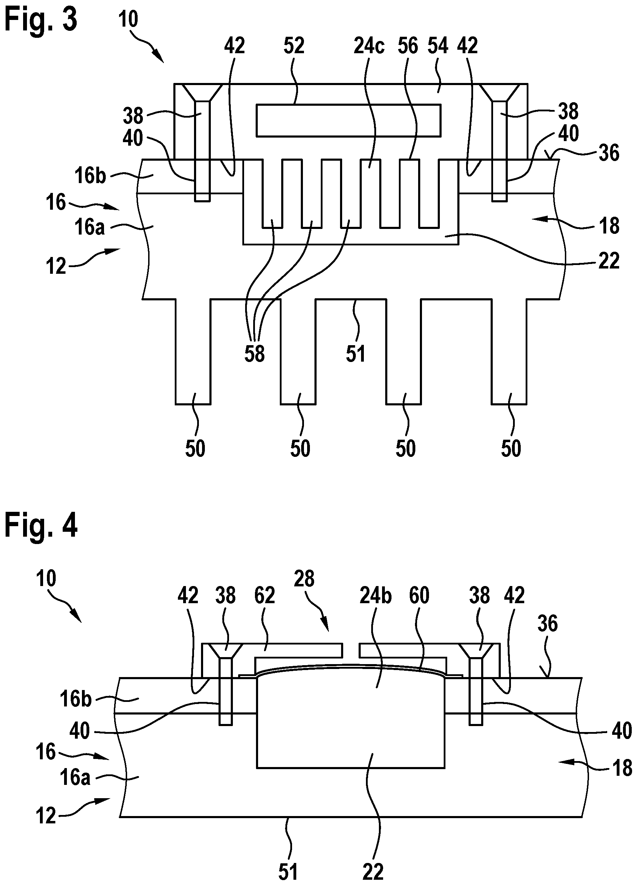

Fig. 3 shows a schematic cross-sectional view of the power electronics device 10 in a section, where a semiconductor module 14 is attached to the base plate 16.

The semiconductor module 14 comprises one or more semiconductor chips 52. The semiconductor chips 52 may be based on SiC, however, also chips based on Si may be used. The semiconductor module 14 furthermore comprises a housing 54, in which the one or more chips 52 are arranged. Electric contacts may protrude from the housing 54, which may be made of plastics material. The housing 54 has a cooling side 56 for dissipating heat generated by the one or more chips 52. The cooling side is directly exposed to the cooling fluid 22 in the receiving opening 24c.

It is possible that the semiconductor module 14 comprises a cooling member 58 protruding into the receiving opening 24c. The cooling member 58, which protrudes from the cooling side 56, is arranged inside the respective receiving opening 24c and is directly exposed to the cooling fluid 22. The cooling member 58 may be provided by pin fins and/or ribbon bonds, which may be bonded to the cooling side 56. In such a way, pin fin modules 14, which are usually used in liquid cooling converters, also may be used in converter systems without a central liquid cooling system.

As shown in Fig. 3, the base plate 16 may comprise a main plate 16a covering the receiving opening 24c.

It may be that the fins 50 are attached to the main plate 16a and/or are one-piece with the mainplate 16b.

Fig. 4 shows a schematic cross-sectional view of the power electronics device 10 in a section, where the expansion element 28 is attached to the base plate 16. The expansion element 28 is integrated in the cooling circuit 18 and allows the cooling fluid 22 to expand and contract due to temperature and pressure variations, which may generate over pressure or under pressure in the hermetically sealed cooling circuit 18.

The expansion element 28 is composed of the expansion element opening 24b, which is closed with a flexible membrane 60, for example made of rubber, and a cover 62. The flexible membrane 60 seals the expansion element opening 24 and is covered by the rigid cover 62 for mechanical protection.

A border of the flexible membrane 60 is clamped between the flat face 42 of the cover 62 and the border of the expansion element opening 24b.

Fig. 4 shows also the possibility that the power electronics device 10 does not have fins 50 on the base plate 16 and in particular does not have fins 50 on the cooling interface 51. There is a flat cooling interface 51 opposite to the mounting surface, where a cooling body can be attached.

In general, it may be that the cooling channels 20a, 20b and the openings 24a, 24b, 24c are integrated into the base plate 16 and form a circular flow path not leaving the base plate 16. In this case, the fins 50 may be massive and/or the cooling channels 20a, 20b may stay outside of the fins 50.

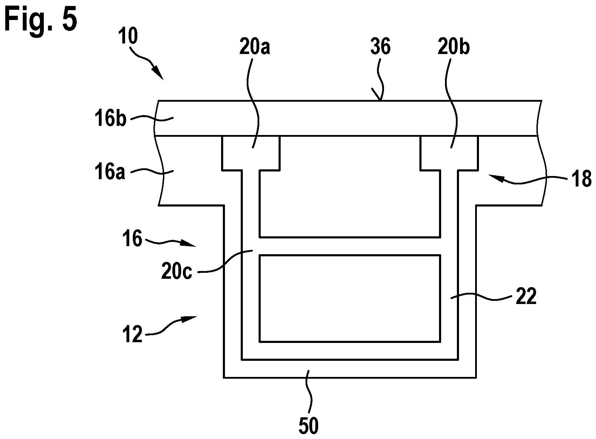

Fig. 5 shows a schematic cross-sectional view of the power electronics device 10 along one fin 50, which comprises internal cooling channels 20c. Fin cooling channels 20c may run through at least some of the fins 50, which cooling channels 20c are interconnected with the cooling channels 20a, 20b in the base plate 16. The cooling channels 20c may enter the fin 50 from the base plate 16 and may return into the base plate 16. The base plate cooling channels 20a, 20b may extend in a plane and at least some of the fin cooling channels 20c may run orthogonal to this plane. Further fin cooling channels 20c may run in parallel to this plane.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: power electronics device
- 12: heat sink
- 14: semiconductor module
- 16: base plate
- 16a: base plate body
- 16b: base plate cover
- 18: cooling circuit
- 20a: cooling channel
- 20b: cooling channel
- 20c: fin cooling channel
- 22: cooling fluid
- 24a: pump opening
- 24b: extension element opening
- 24c: receiving opening
- 26: pump
- 28: expansion element
- 30: heat spreading section
- 32: module section
- 34a: inlet
- 34b: outlet
- 36: mounting surface
- 38: mounting means
- 40: mounting hole
- 42: flat face
- 44: sealing ring
- 46: pump body
- 48: conveyer
- 50: fin
- 51: cooling interface
- 52: semiconductor chip
- 54: housing
- 56: cooling side
- 58: cooling member
- 60: flexible membrane
- 62: cover

## Claims

1. A power electronics device (10), comprising:
a base plate (16) with a cooling circuit (18);
a pump (26) attached to the base plate (16) for conveying cooling fluid (22) through the cooling circuit (18);
at least one semiconductor module (14) attached to a mounting surface (36) of the base plate (16);
wherein the cooling circuit (18) comprises at least one receiving opening (24c) in the base plate (16), which receiving opening (24c) is opened towards the mounting surface (36);
wherein the at least one receiving opening (24c) is sealed by the at least one semiconductor module (14);
wherein the pump (26) and the at least one receiving opening (24c) are interconnected with cooling channels (20a, 20b) running through the base plate (16) below the mounting surface (36), such that the receiving opening (24c) is integrated into the cooling circuit (18), cooling fluid (22) is conveyable by the pump (26) through the at least one receiving opening (24c) and the at least one semiconductor module (14) is directly exposed to the cooling fluid (22);
wherein the base plate (16) comprises a cooling interface (51) for cooling the cooling fluid (22).

2. The power electronics device (10) of claim 1,
wherein the semiconductor module (14) comprises a cooling member (58) protruding into the receiving opening (24c).

3. The power electronics device (10) of claim 1 or 2,
wherein the cooling circuit (18) comprises a pump opening (24a) in the base plate (16), which pump opening (24a) is interconnected with the cooling channels (20a, 20b) in the base plate (16);
wherein the pump (26) seals the pump opening (24a) with a pump body (46) and the pump opening (24a) accommodates at least a conveying part of the pump (26).

4. The power electronics device (10) of one of the previous claims,
wherein at least one of the cooling channels (20b) meanders through the base plate (16).

5. The power electronics device (10) of one of the previous claims,
wherein the cooling interface (51) is arranged opposite to the mounting surface (36).

6. The power electronics device (10) of one of the previous claims,
wherein the cooling interface (51) comprises fins (50), which protrude from the base plate (16).

7. The power electronics device (10) of claim 6,
wherein through at least some of the fins (50) run fin cooling channels (20c), which are interconnected with the cooling channels (20a, 20b) in the base plate (16).

8. The power electronics device (10) of claim 7,
wherein the base plate cooling channels (20a, 20b) extend in a plane and at least some of the fin cooling channels (20c) protrude from the plane.

9. The power electronics device (10) of one of the previous claims,
wherein the cooling circuit (18) comprises an expansion element opening (24b) in the base plate (16), which expansion element opening (24b) is interconnected with the cooling channels (20a, 20b) in the base plate (16);
wherein the expansion element opening (24b) is sealed with a flexible membrane (60).

10. The power electronics device (10) of one of the previous claims,
wherein at least one of an inlet (34a) and outlet (34b) interconnected in the cooling circuit (18) is connected to the base plate (16).

11. The power electronics device (10) of one of the previous claims,
wherein the base plate (16) comprises a main plate (16a) providing the at least one receiving opening (24c) and the base plate cooling channels (20a, 20b) and a cover plate (16b) covering the base plate cooling channels (20a, 20b) and having at least one hole exposing the at least one receiving opening (24c).

12. The power electronics device (10) of claim 11,
wherein the cooling interface (51) is provided by the main plate (16a).

13. The power electronics device (10) of claim 11 or 12,
wherein the at least one receiving opening (24c) and the base plate cooling channels (20a, 20b) are machined into one side of the main plate (16a).

14. The power electronics device (10) of one of the preceding claims,
wherein fins (50) are attached to the base plate (16) and/or to the cooling interface (51).
